# EUROPEAN PATENT APPLICATION

(11) **EP 4 425 259 A1**
(43) Date of publication of application: **04.09.2024**
(21) Application number: 23159066.2
(22) Date of filing: 28.02.2023
(51) Int. Cl.: G03F 7/00, H01L 21/683, H01L 21/687

(54) **METHOD OF MANUFACTURING AN ELECTROSTATIC OBJECT CLAMP, ELECTROSTATIC OBJECT CLAMP AND SEMICONDUCTOR PROCESSING APPARATUS**

(71) Applicant: ASML Netherlands B.V., 5500 AH Veldhoven (NL)
(72) Inventor: WIGGERS, Frank, Bert, 5500 AH Veldhoven (NL); LUDWIG, Heike, 5500 AH Veldhoven (NL); ALLSOP, Nicholas, Alan, 5500 AH Veldhoven (NL); WARMING, Till, 5500 AH Veldhoven (NL); HALM, Simon, 5500 AH Veldhoven (NL)
(74) Representative: ASML Netherlands B.V.

(57) **Abstract**

The invention provides a method of manufacturing an electrostatic object clamp for a semiconductor processing apparatus, the method comprising the steps of:
- providing an electrode with a dielectric substrate,
- depositing a coating on a top surface of the dielectric substrate by alternatingly depositing:
- one or more electrically conductive base layers, and
- one or more electrically conductive protective layers, and

- laser ablating the coating to form one or more recesses in the coating to obtain a three-dimensional coating structure, and
- removing all areas of the one or more protective layers that are exposed after the step of laser ablating.

## Description

### FIELD

The present invention relates to a method of manufacturing an electrostatic object clamp for a semiconductor processing apparatus. The present invention further relates to an electrostatic object clamp for a semiconductor processing apparatus and to a semiconductor processing apparatus, for example a lithographic apparatus, comprising the electrostatic object clamp.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

It is known in the art to build electrostatic object clamps by depositing electrically conductive material on dielectric substrates of electrodes. These clamps typically have a three-dimensional structure, comprising multiple supports for supporting the objects, such as semiconductor substrates. All supports of the object clamp are surrounded by an annular gas holding seal and each individual support is surrounded by interconnected grounding structures for grounding the supports relative to the substrate.

The known object clamps are typically manufactured by depositing an even coating layer of conductive material, for example of about 10 µm thickness. The even coating layer is then ablated to create height differences for forming the three-dimensional coating structure. Next, the coating structure is etched to remove all excess material surrounding the supports and the gas holding seal. Finally, a second coating layer is deposited and etched to form the grounding structures, directly on the dielectric substrate.

The known methods for manufacturing electrostatic object clamps have the drawback that they require multiple deposition steps, multiple ablation steps and multiple etching steps before the final object clamp is obtained. This may give rise to relatively long cycle times, of up to several weeks, thereby having a lower productivity. Furthermore, the semi-finished object clamps remain exposed to particles during all these manufacturing steps, which may contaminate the object clamp and which reduces yield.

### SUMMARY

It is an object of the invention to provide a method of manufacturing an electrostatic object clamp for a semiconductor processing apparatus that has a reduced cycle time and an improved yield. It is a further object of the invention to provide an electrostatic object clamp for a semiconductor processing apparatus, and a semiconductor processing apparatus, of which the manufacturing has a reduced cycle time and improved yield for manufacturing.

According to an aspect of the present invention, there is provided a method of manufacturing an electrostatic object clamp for a semiconductor processing apparatus, the method comprising the steps of:
- providing an electrode with a dielectric substrate,
- depositing a coating on a top surface of the dielectric substrate by alternatingly depositing:
   - one or more electrically conductive base layers, and
   - one or more electrically conductive protective layers, and
- laser ablating the coating to form one or more recesses in the coating to obtain a three-dimensional coating structure, and
- removing all areas of the one or more protective layers that are exposed after the step of laser ablating.

According to the present method, one or more protective layers are alternatingly embedded in between base layers. The protective layers serve the purpose of forming an etch-stop layer to locally prevent etching of the base layers and of locally protecting the base layers against laser ablation, where no removal of base layer material is needed. During deposition of the initial coating, the deposition target may be switched between the base layer material and the protective layer material, to alternatingly deposit base layers and protective layers.

Compared to existing methods of manufacturing object clamps, the present method differs in that the final structure is already anticipated for during the deposition of the coating, since the alternating layers, i.e. their thicknesses, determine the heigh profile of the structure. The height profile of the object clamp is, according to the present method, not determined by the ablation alone. Instead, the ablating serves the purpose of pre-structuring the coating, by rough removal of coating material, whereas the final height profile is determined by the removal of the protective layers, etching of the base layers and the initial, as-deposited thicknesses of the protective layers and base layers.

According to the present method, the removal of coating material to obtain the final structure is carried out by means of ablation and removing of protective material. The removal of coating material in an x-y plane, i.e. a horizontal plane parallel to the dielectric substrate, is carried out by means of the laser ablation. Furthermore, the removal of coating material in a z-direction, i.e. a vertical direction perpendicular to the x-y plane, is carried out by means of the removal step. Optionally, part of the removal of the material in the z-direction may also be established by means of the laser ablation.

For the present invention, the base layer material and the protective layer material are preferably selected such, that their etch selectively is substantially different. In this way, it can be prevented that the base layers are etched during the step of removing of the protective layers and it can be prevented that the protective layers are etched during the optional step of etching of the base layers. The etch selectivity may apply both for chemical selectivity, in case the removing of the protective layers involves chemical etching, and for dry etching, in case the removing of the protective layers involves dry etching, such as reactive ion etching (RIE).

The present method provides the benefit that only a single deposition step, a single ablation step, a single step of removing the protective layers and, if any, a single etching step is required. These single steps may provide the benefit that the overall cycle time is reduced, compared to the cycle times needed to manufacture object clamps according to the existing method. Furthermore, the reduced cycle time may reduce the risk of particle contamination of the clamps, thereby improving overall yield.

According to an aspect of the present invention, there is provided an electrostatic object clamp for a semiconductor processing apparatus, comprising:
- an electrode with a dielectric substrate,
- a coating, applied on a top surface of the dielectric substrate,

wherein the coating comprises one or more electrically conductive base layers and one or more electrically conductive protective layers, which are applied alternatingly, and
wherein the coating is provided as a three-dimensional coating structure, comprising one or more recesses.

According to an aspect of the present invention, there is provided a semiconductor processing apparatus, for example a lithographic apparatus, comprising the present electrostatic object clamp.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a detailed view of a part of the lithographic apparatus of Figure 1;
- Figure 3 schematically depicts a position control system;
- Figures 4A - 4D schematically depict a first embodiment of the invention;
- Figures 5A - 5C schematically depict a second embodiment of the invention; and
- Figures 6A - 6H schematically depict a third embodiment of the invention.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

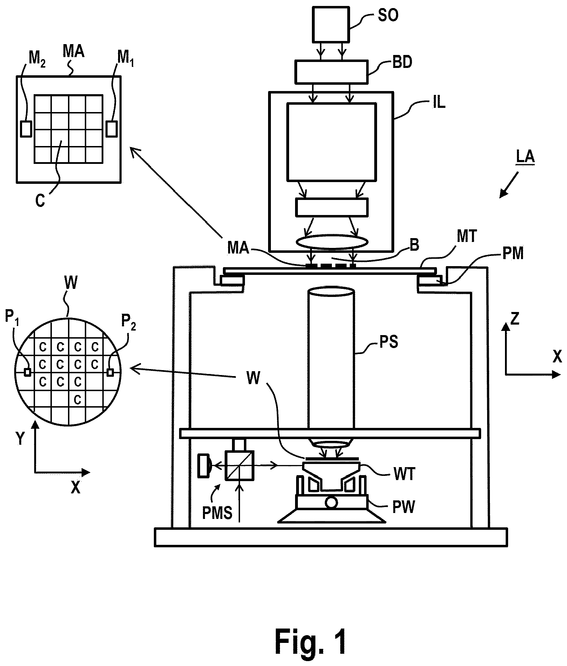

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system PMS, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

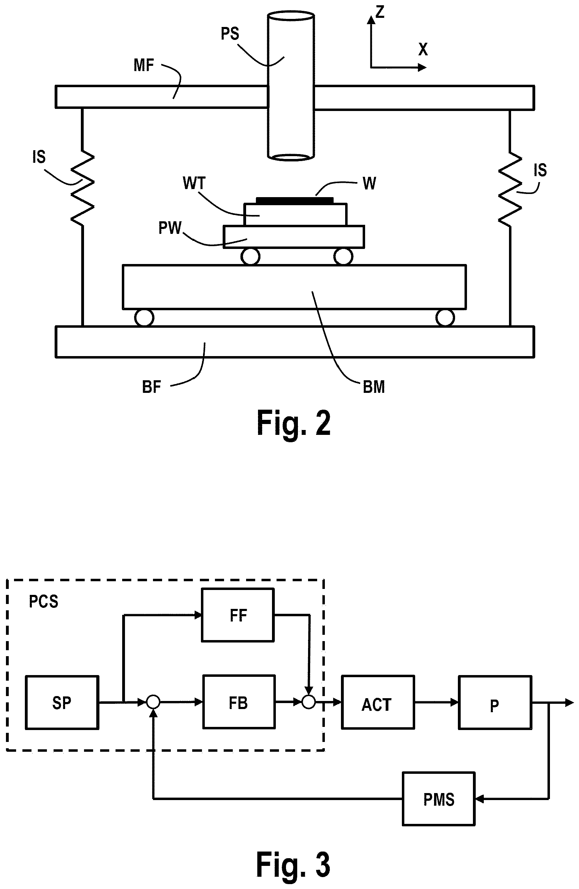

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor. a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example,+1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads are arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

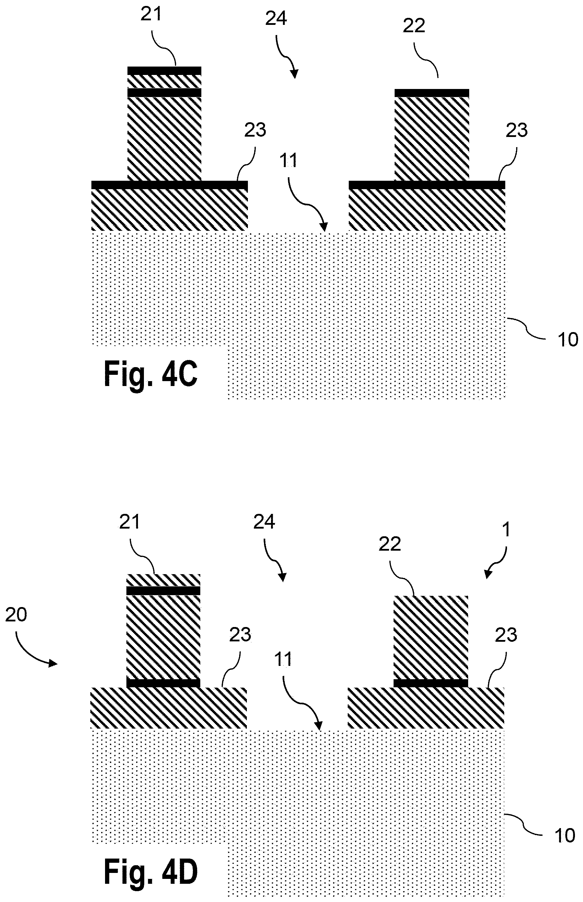

The present invention relates to a method of manufacturing an electrostatic object clamp for a semiconductor processing apparatus. Part of such an object clamp is shown in figure 4D in a crosssectional view, in which figure the object clamp is referred to with reference numeral 1. The object clamp 1 comprises a dielectric substrate 10, having a top surface 11. In the present embodiments, the substrate 10 comprises a glass material.

A three-dimensional coating structure 20 is built on the substrate 10, made of an electrically conductive material. With the term "three-dimensional" structure 20, it is meant that the structure 20 comprises a pattern of objects on the substrate 10 having a height profile that varies across the top surface 11. The structure 20 comprises a plurality of supports 21 for supporting objects, such as semiconductor substrates, during use of the object clamp 1. Generally speaking, the supports 21 form the highest points of the structure 20, thereby being able to hold the objects. All supports 21 of the object clamp 1 are surrounded by an annular gas holding seal 22. The gas holding seal 22 serves the purpose of holding gas around the supports 21. Each of the supports 21 and the gas holding seal 22 is provided with grounding structures 23 on opposite sides. The grounding structures 23 form the lowest points of the structure 20 and are all interconnected, in order to ground the supports 21 and the gas holding seal 22 relative to the substrate 10. In the recesses 24 of the structure 20, located in between the neighbouring grounding structures 23, the top surface 11 of the substrate 10 remains exposed in the final object clamp 1.

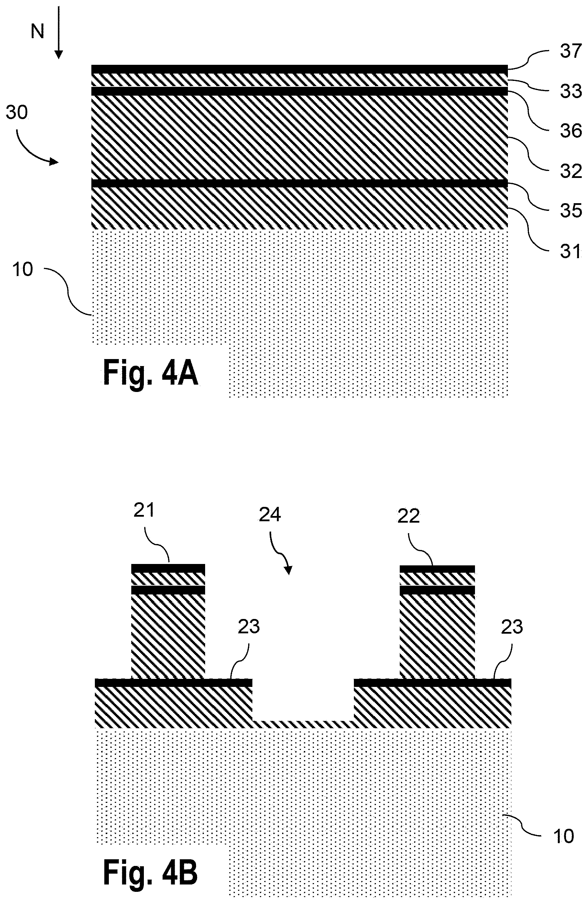

During the present method of manufacturing the object clamp 1, the electrode with the dielectric substrate 10 is provided first. A coating 30 is applied on the top surface 11, as is displayed in figures 4A, 5A and 6A. The coating 30 comprises multiple different layers, depending on the final structure 20 that is to be obtained. The thicknesses of the various layers in the coating 30 may vary, depending on the final structure 20 that is to be obtained as well, wherein these thicknesses may be controlled by controlling a deposition duration for each of the layers. In the present embodiments shown in the figures, the overall thickness of the coating, e.g. all layers thereof combined, is about 10 µm, whereas the individual protective layers 35, 36, 37, 38 may have a relatively small thickness of less than 1 µm.

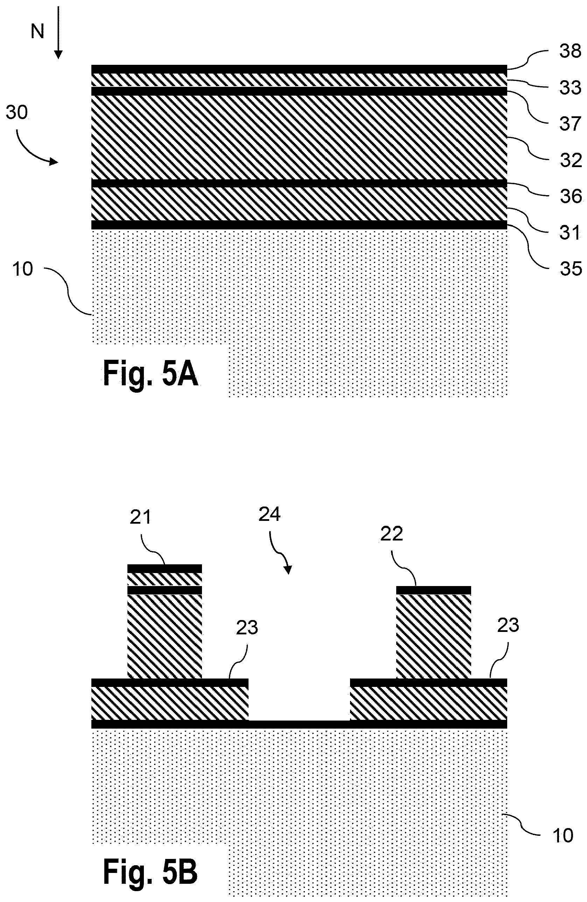

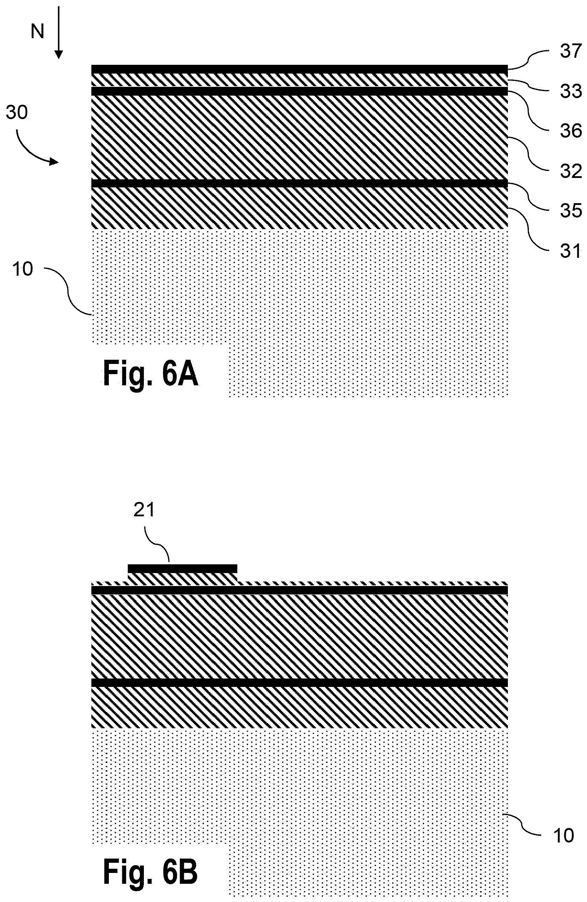

According to the present method, the thicknesses of the layers in the coating 30 are selected in relation to the desired height profile of the structure 20 that is to be created for the object clamp 1. For example, for the object clamps 1 in the embodiments of figures 4A - 4D and 6A - 6H, the height of a first base layer 31 may be selected to correspond to the desired height of the grounding structures 23. The combined height of the first base layer 31, a first protective layer 35 and a second base layer 32 may be selected to correspond to the desired height of the gas holding seal 22. Finally, the combined height of the first base layer 31, the first protective layer 35, the second base layer 32, a second protective layer 36 and a third base layer 33 may be selected to correspond to the desired height of the supports 21. Alternatively, for the object clamp 1 in the embodiment of figures 5A - 5C, the height of the structure 20 may additionally include the thickness of the first protective layer 35 that is provided directly on the substrate 10.

The coating 30 of the first embodiment of the object clamp 1, shown in figure 4A, first comprises the first base layer 31, directly on the top surface 11 of the substrate 10. Next, the first protective layer 35 is provided on the first base layer 31, followed by the second base layer 32, the second protective layer 36, the third base layer 33 and a third protective layer 37. A similar configuration of coating layers is visible in the coating 30 of the third embodiment of the object clamp 1, shown in figure 6A.

The coating 30 of the second embodiment of the object clamp 1, shown in figure 5A, is different, comprising the first protective layer 35 directly on the top surface 11 of the substrate 10, followed by the first base layer 31, the second protective layer 36, the second base layer 32, the third protective layer 37, the third base layer 33 and, finally, a fourth protective layer 38 on top.

In the present embodiments, the base layers 31, 32, 33 are made of a Chromium Nitride (CrN) material, which is advantageous due to its electrically conducting properties and mechanical hardness that is relatively high. Similarly, the base layers 31, 32, 33 may be made of a Titanium Nitride (TiN) material, or any other suitable material. The base layers 31, 32, 33 are deposited on the substrate 10 by means of deposition, for example by means of Chemical Vapour Deposition (CVD), in a manner similar to the deposition in the existing methods of manufacturing object clamps.

In the present embodiments, the protective layers 35, 36, 37, 38 are metallic layers made of metallic Titanium (Ti) and metallic Silicon (Si), but can be of Aluminum (Al) as well. The Titanium, Silicon and/or Aluminum layers are beneficial for the present invention, to obtain the desired protective properties during the manufacturing of the object clamp 1. The protective layers 35, 36, 37, 38 are deposited on the substrate 10 by means of deposition as well. The deposition of the protective layers 35, 36, 37, 38 may take place during the same process as the deposition of the base layers 31, 32, 33, for example by switching between deposition targets when a desired layer thickness has been achieved.

The protective layers 35, 36, 37, 38 are multilayers, comprising alternating layers of the metallic material, i.e. alternating layers of Titanium and Silicon arranged on top of each other. The multilayer protective layers 35, 36, 37, 38 offer the benefit of allowing post-processing, by removing either one of the materials, i.e. layers, instead of both of them in a combined removing step. This may enable fine adjustment of the height of the structure 20 after the steps of ablating, etching of the base layers and removing of the protective layers have been carried out.

In general, the protective layers may be made of any material that has a substantially large etch selectivity relative to the base layer material, for example the Titanium Nitride or Chromium Nitride, used for manufacturing the base layers. This difference in etch selectivity is beneficial to avoid the risk of undesired etching of either one of the protective layers or base layers when etching of the other one of the protective layers or base layers is intended.

The structures 20 of the final object clamps 1 have exposed areas, i.e. seen from above in the direction N normal to the top surface 11. All exposed areas of the structure 20 are formed by the base layers 31, 32, 33, as is best shown in figures 4D, 5C and 6H. Furthermore, the exposed areas of the structure are generally free of the protective layers 35, 36, 37, 38, when seen from above.

After applying the coating 30 on the substrate 10, the coating 30 is subjected to three-dimensional laser ablation, to transform the initially smooth coating 30 into the three-dimensional structure 20, having a texture with height differences over the surface. The ablation of the coating 30 thereby concerns ablation of both one or more of the base layers 31, 32, 33 and one or more of the protective layers 35, 36, 37, 38.

The ablation of the coating 30 may leave a relatively rough surface behind, compared to the relatively low surface-roughness of the base layers 31, 32, 33 as-deposited. Furthermore, the depth of the ablation may not be controllable to the desired degree of accuracy. Finally, if the ablation were to be carried out too far, i.e. towards the substrate 10, the laser ablation may damage the glass material of the substrate 10. To this extent, the step of ablation is followed by a step of removing the exposed areas of the protective layers 35, 36, 37, 38 and optionally the step of etching all exposed areas of the base layers 31, 32, 33. With the term "exposed" areas of layers, all areas of these respective layers are meant that are not covered by any other layers, seen in the direction N normal to the layers.

The removing of the exposed areas of the protective layers 35, 36, 37, 38 may involve etching of the protective layers 35, 36, 37, 38 with an etchant, for example a chemical etchant, having an etch selectivity chosen to be able to remove the protective layers 35, 36, 37, 38, whilst not being an etchant for the base layers 31, 32, 33. This may enable that only the protective layers 35, 36, 37, 38 are etched until the base layers 31, 32, 33 become exposed. These base layers 31, 32, 33 will not be etched, so that the etching of the protective layers 35, 36, 37, 38 is eventually stopped.

Likewise, the etching of the exposed areas of the base layers 31, 32, 33 may involve etching of the base layers 31, 32, 33 with an etchant, for example a chemical etchant, having an etch selectivity chosen to be able to remove the base layers 31, 32, 33, whilst not being an etchant for the protective layers 35, 36, 37, 38. This may enable that only the base layers 31, 32, 33 are etched until the protective layers 35, 36, 37, 38 become exposed. These protective layers 35, 36, 37, 38 will not be etched, so that the etching of the base layers 31, 32, 33 is eventually stopped.

Compared to existing methods, which heavily relied on the ablation of the base layers, the etching may give rise to fewer particles in the air. Especially where the base layers comprise Chromium Nitride, the Chromium (Cr(VI)-) particles may give rise to health risks, being toxic and carcinogenic. The etching, i.e. chemical etching, in the present method may result in fewer particles ending up in the surrounding air.

Alternatively, the removing, e.g. etching, of the protective layers and the etching of the base layers may involve dry etching of the layers, for example by means of a reactive ion etching (RIE) process.

The removing, e.g. etching, of the base layers 31, 32, 33 and the protective layers 35, 36, 37, 38 concerns directional etching of the layers in the direction N normal to the substrate 10, whilst minimizing etching in directions having a component parallel to the substrate 10. This may improve the accuracy of the lateral dimensions of the structures 20 on the substrate 10, seen in directions parallel to the substrate 10.

In the embodiment of figures 4A - 4D, the step of ablating is shown in figure 4B. During this ablation step, the support 21 is formed by ablating the surrounding second base layer 32, second protective layer 36, third base layer 33 and third protective layer 37. The first base layer 31 and first protective layer 35 surrounding the support 21 are not ablated, in order to form the surrounding grounding structures 23. At the gas holding seal 22, the third protective layer 37 is ablated as well, in order to expose the third base layer 33 on top of the gas holding seal 22. The gas holding seal 22 and surrounding grounding structures 23 are formed in a manner similar to the supports 21, namely by ablating the surrounding second base layer 32, second protective layer 36, third base layer 33 and third protective layer 37. In between the grounding structures 23 of the supports 21 and the gas holding seal 22, the first protective layer 35 and part of the first base layer 31 are ablated as well to form the recess 24 in between the supports 21 and the gas holding seal 22. The first base layer 31 is preferably not ablated in full, to not yet expose the substrate 10 in the recess 24, in order to protect the substrate 10 against undesired damaging and structural changes from the laser during the ablation.

The ablating of the base layers 31, 32, 33 and the protective layers 35, 36, 37, 38 may be used to roughly define the height profile of the structure 20. The final height adjustments are carried out by means of the removal of the protective layers 35, 36, 37, 38 and the etching of the base layers 31, 32, 33. For example at the grounding structures 23, the ablating may be carried to a depth corresponding to the first protective layer 35. It would be acceptable when the ablating would include minor ablation of the first protective layer 35, because this layer 35 is removed at a later stage, not forming part of the final object clamp 1 that is to be created. The same applies for the third base layer 33 exposed on top of the gas holding seal 22 after the ablating.

As a next step in this method, shown in figure 4C, the exposed areas of the base layers 31, 32, 33 are etched away. This concerns the etching of the third base layer 33 exposed on top of the gas holding seal 22, in order to expose the second protective layer 36 at the gas holding seal 22. Furthermore, the step of etching concerns removal of the first base layer 31 exposed in the recess 24 in between the grounding structures 23 of the supports 21 and the gas holding seal 22, in order to expose the top surface 11 of the substrate 10 in the recess 24. The latter offers the benefit that the top surface 11 of the substrate 10 is exposed by means of an etching step, not by laser ablation, to avoid undesired damaging and structural changes of the substrate 10.

The final step of this method, shown in figure 4D, involves removal of the exposed areas of the protective layers 35, 36, 37, 38. During this step, the exposed areas of the first protective layer 35 at the grounding structures 23 are removed, as well as the exposed areas of the second protective layer 36 at the gas holding seal 22 and the exposed areas of the third protective layer 37 at the supports 21. By removing all exposed areas of the protective layers 35, 36, 37, 38, the top surfaces of the structure 20 of the object clamp 1 become solely formed by material from the base layers 31, 32, 33.

These steps of the present method yield the final electrostatic object clamp 1 shown in figure 4D, wherein the method advantageously only involves a single deposition step, a single ablation step, a single etching step for etching base layers 31, 32, 33 and a single removal step for removing protective layers 35, 36, 37, 38.

In figures 5A - 5C, a second embodiment of the present method is displayed, which is free of an etching step for etching base layers 31, 32, 33. This is due to the lowermost layer of the coating 30, directly on the top surface 11 of the substrate 10, being the first protective layer 35. The coating 30 thereby includes seven layers in total. A protective layer 35, 36, 37, 38 is present underneath each of the base layers 31, 32, 33, as well as on top of the third base layer 37 to protect the upper surface of the support 21.

The step of ablating is shown in figure 5B, which differs from the ablating in figure 4B in that the first base layer 31 is completely removed by ablation in the recess 24, i.e. in between the grounding structures 23 of the supports 21 and the gas holding seal 22. The first protective layer 35 can be partly ablated as well and serves to protect the substrate underneath it. With the ablating, all excess parts of the base layers 31, 32, 33 are removed, so that no separate etching of base layers 31, 32, 33 is needed.

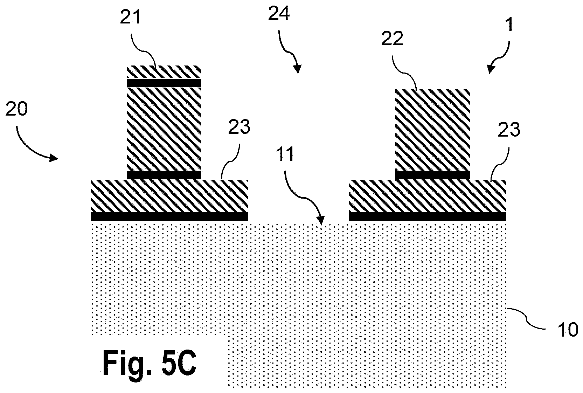

After the step of ablating, the present method only requires the step of removing exposed areas of the protective layers 35, 36, 37, 38. In the embodiment shown in figure 5C, this concerns removal of the exposed area of the first protective layer 35 on the substrate 10, in between the grounding structures 23, as well as removal of the exposed areas of the second protective layer 36 at the grounding structures 23, the exposed areas of the third protective layer 37 at the gas holding seal 22 and the exposed areas of the fourth protective layer 37 at the supports 21. By removing all exposed areas of the protective layers 35, 36, 37, 38, the top surfaces of the structure 20 of the object clamp 1 become solely formed by material from the base layers 31, 32, 33.

Finally, figures 6A - 6H depict a third embodiment of the present method. It is shown in figure 6A that the coating 30 is built-up with similar layers as the embodiment in figure 4A, although the thicknesses of the layers may differ. This method of figures 6A - 6H involves three ablation steps, three steps of etching the base layers 31, 32, 33 and one step of removing protective layers 35, 36, 37, 38. Although this method involves multiple steps of ablating and etching, the single deposition step and the single step of removing the protective layers 35, 36, 37, 38 may still offer a benefit over the known methods, in terms of cycle time and yield. Furthermore, the vast majority of the material from the base layers 31, 32, 33 is removed by means of etching, thereby minimizing the amount of base layer material that needs to be ablated, thus further reducing health risks.

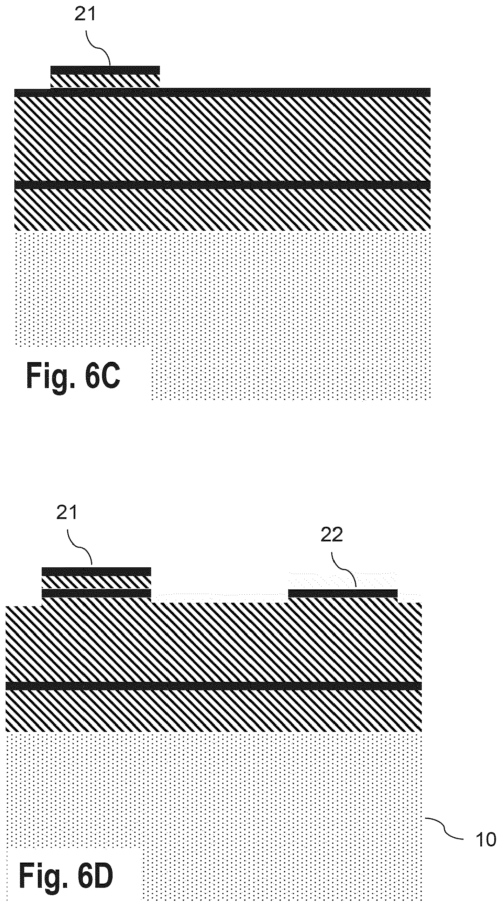

As a first step, shown in figure 6B, the third protective layer 37 and, optionally, the third base layer 33 are ablated at areas surrounding the support 21. The third base layer 33 is ablated partly, seen along the direction N normal to the substrate 10, so as not to damage the second protective layer 32. The remaining parts of the third base layer 33 are etched, as is shown in figure 6C, to expose the second protective layer 32.

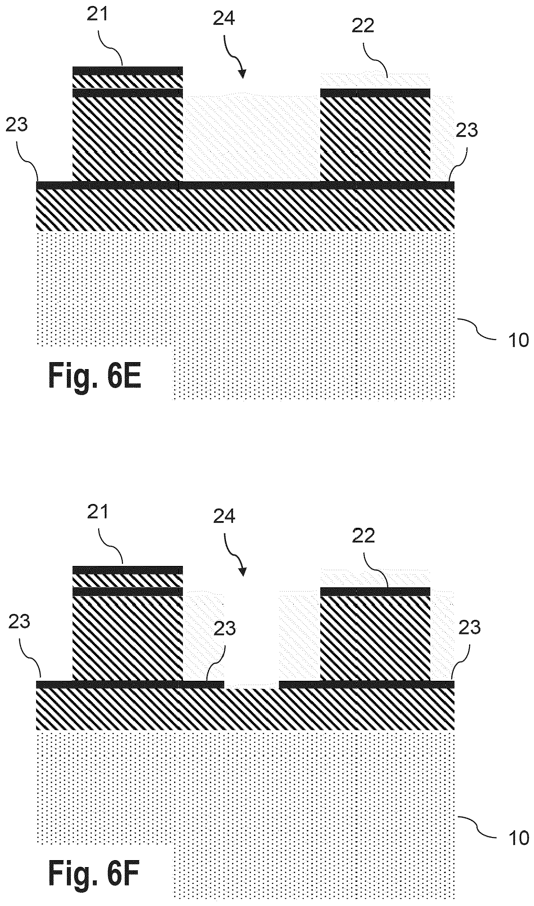

The steps of ablating and etching are repeated at areas surrounding the gas holding seal 22, as shown respectively in figure 6D and 6E. Here, the second protective layer 36 and, optionally, the second base layer 32 are ablated at areas surrounding the gas holding seal 22. The remaining parts of the second base layer 32 are etched, as is shown in figure 6E, to expose the first protective layer 31.

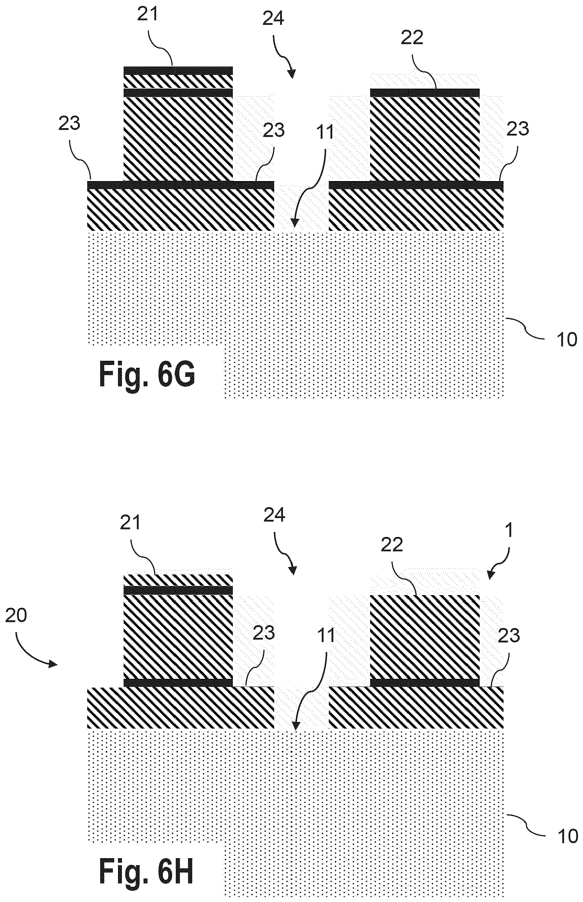

Then, the steps of ablating and etching are repeated once more, as shown respectively in figure 6F and 6G. This third ablation step concerns ablation of the first protective layer 35 and, optionally, the first base layer 31 in the recess 24, in between the grounding structures 23 of the supports 21 and the gas holding seal 22. During etching, the first base layer 31 in between the grounding structures 23 is etched, as shown in figure 6G, to expose the top surface 11 of the substate 10.

Finally, the method comprises the step of removing all exposed areas of the protective layers 35, 36, 37, 38 to obtain the final object clamp 1. This step is shown in figure 6H, involving removal of the exposed areas of the first protective layer 35 at the grounding structures 23, of the exposed areas of the second protective layer 36 at the gas holding seal 22 and of the exposed areas of the third protective layer 37 at the supports 21. By removing all exposed areas of the protective layers 35, 36, 37, 38, the top surfaces of the structure 20 of the object clamp 1 become solely formed by material from the base layers 31, 32, 33.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of manufacturing a clamp for a semiconductor processing apparatus, the method comprising the steps of:
- providing a dielectric substrate,
- deposition a coating on a top surface of the dielectric substrate by alternatingly depositing:
- one or more base layers, and
- one or more protective layers, and
- laser ablating the coating to form one or more recesses in the coating to obtain a three-dimensional coating structure, and
- removing all areas of the one or more protective layers that are exposed after the step of laser ablating.

2. The method according to claim 1, wherein the step of removing the exposed areas of the one or more protective layers comprises etching of the protective layers.

3. The method according to claim 2, wherein the etching of the protective layers comprises chemical etching using an etchant capable of removing the protective layers.

4. The method according to any of the preceding claims, wherein the step of depositing the coating first comprises the depositing of one of the protective layers, directly on the top surface of the dielectric substrate, to form a lowermost protective layer on the dielectric substrate, and
wherein the step of removing all areas of the one or more protective layers includes removing of the exposed areas of the lowermost protective layer on the dielectric substrate.

5. The method according to any of the preceding claims, further comprising, after the step of laser ablating and prior to the step of removing the exposed areas of the one or more protective layers, the step of etching all areas of the one or more base layers that are exposed after the step of laser ablating, until exposing the one or more protective layers underneath.

6. The method according to claim 5, wherein the etching of the base layers comprises chemical etching using an etchant capable of removing the base layers.

7. The method according to claim 5 or 6, wherein the step of depositing the coating first comprises the depositing of one of the base layers, directly on the top surface of the dielectric substrate, to form a lowermost base layer on the dielectric substrate, and
wherein the step of etching all areas of the one or more base layers includes removing of the exposed areas of the lowermost base layer on the dielectric substrate.

8. The method according to any of the preceding claims, wherein the step of laser ablating comprises three-dimensional laser ablating or/and
wherein the step of laser ablating comprises laser ablating one or more of the base layers.

9. The method according to any of the preceding claims, wherein the base layers comprise Chromium Nitride (CrN) and/or Titanium Nitride (TiN) or/and
The method according to any of the preceding claims, wherein the protective layers comprise Titanium (Ti), Silicon (Si) and/or Aluminum (Al).

10. The method according to claim 9, wherein each protective layer is a multilayer comprising alternating layers of Titanium (Ti) and Silicon (Si).

11. A clamp for a semiconductor processing apparatus, comprising:
- a dielectric substrate,
- a coating, applied on a top surface of the dielectric substrate,
wherein the coating comprises one or more base layers and one or more protective layers, which are applied alternatingly, and
wherein the coating is provided as a three-dimensional coating structure.

12. The clamp according to claim 11, wherein all exposed areas of the structure are formed by the one or more base layers, being free of the one or more protective layers.
or/and wherein the dielectric substrate is exposed in the recesses of the coating structure.

13. The clamp according to claims 11- 12, wherein the base layers comprise Chromium Nitride (CrN) and/or Titanium Nitride (TiN) or/and wherein the protective layers metallic layers, for example comprising Titanium (Ti), Silicon (Si) and/or Aluminum (Al).

14. The clamp according to claim 13, wherein each protective layer is a multilayer comprising alternating metallic layers of Titanium (Ti) and Silicon (Si).

15. Semiconductor processing apparatus comprising the clamp according to any of the preceding claims.
